# FASCICULE DE BREVET EUROPEEN

(11) **EP 1 759 411 B1**
(45) Date de publication et mention de la délivrance du brevet: **30.05.2012**
(21) Numéro de dépôt: 05776391.4
(22) Date de dépôt: 02.06.2005
(51) Int. Cl.: H01L 21/683

(54) **PROCEDE DE TRANSFERT DE PLAQUES**
VERFAHREN ZUR ÜBERTRAGUNG VON PLATTEN
METHOD FOR TRANSFERRING PLATES

(30) Priorité: 02.06.2004 FR 0451085
(43) Date de publication de la demande: 07.03.2007
(73) Titulaire: Soitec, 38190 Bernin (FR)
(72) Inventeur: ASPAR, Bernard, F-38140 RIVES (FR); LAGAHE-BLANCHARD, Chrystelle, F-38134 SAINT-JOSEPH-DE-RIVIERE (FR)
(74) Mandataire: Poulin, Gérard
(86) Numéro de dépôt international: PCT/FR2005/050411
(87) Numéro de publication internationale: WO 2005/124826

(56) Documents cités:
- EP-A- 1 251 557
- FR-A- 2 828 579
- US-A- 5 780 354
- US-A- 6 013 534
- US-A1- 2002 115 263
- US-B1- 6 214 733

## Description

### DOMAINE TECHNIQUE ET ART ANTERIEUR

L'invention concerne le domaine de la microélectronique et des techniques mises en oeuvre dans ce domaine pour effectuer un transfert de plaque ou de substrat sur une autre plaque ou un autre substrat ou pour effectuer un traitement d'une surface d'une plaque.

Dans ce domaine de la microélectronique, il est notamment important de pouvoir réaliser des transferts de couches minces contenant des circuits. Ces transferts de couches minces permettent en particulier de reporter les circuits sur des plaques différentes de celles qui ont servi à les élaborer.

Par exemple, ces plaques peuvent être des plaques de silice fondue, des plaques de matériau semi-conducteur contenant, ou pas, des composants électroniques.

Plusieurs techniques peuvent être utilisées pour transférer des couches déjà traitées ou « processées ».

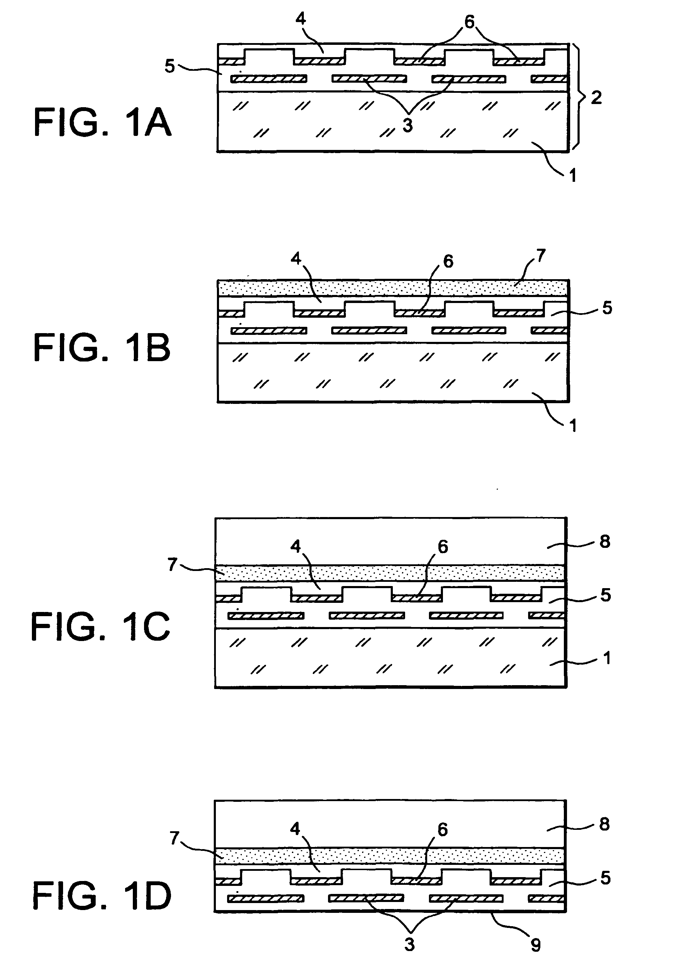

Une des techniques, illustrée sur les figures 1A - 1D consiste à coller une plaque 2 contenant une couche traitée 5 (par exemple qui contient des circuits 3 et des plots 6 de contact électrique : figure 1A) sur une plaque définitive 8 (figure 1C) .

Ensuite, la partie 1 de la plaque initiale 2 ne contenant pas la zone traitée est éliminée, par exemple par rectification, polissage mécanique ou mécano-chimique ou par attaque chimique (sèche ou (humide).

La surface de la plaque 5 contenant les circuits et les contacts 6 se trouve alors enterrée au niveau de l'interface de collage (figure 1D).

Dans certains cas, il est nécessaire d'avoir la surface de la plaque 5 au niveau de la surface de la structure finale : il faut alors réaliser un double transfert afin de remettre la surface traitée vers le haut. On peut ainsi retrouver en surface les plots de connexion et reprendre les contacts de façon standard.

Le premier transfert s'effectue comme précédemment mais, dans ce cas, la plaque 5 avec les circuits est tout d'abord collée sur une plaque intermédiaire (la plaque 8 de la figure 1D), dite aussi « poignée ».

La partie inutile de la plaque initiale est éliminée, par exemple par rectification, polissage ou attaque chimique.

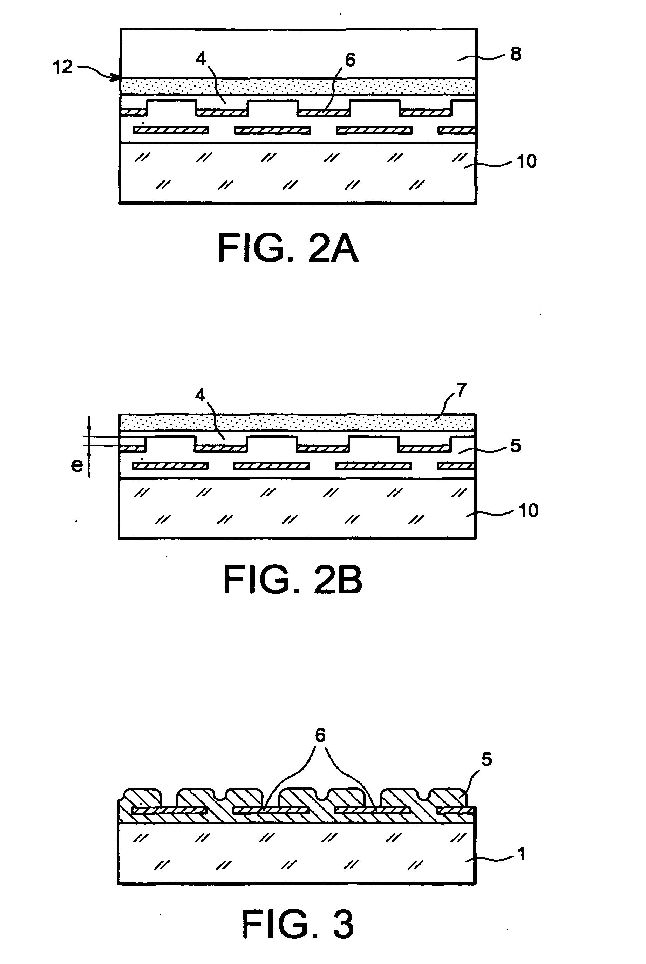

Ensuite, la face arrière amincie de la couche traitée est préparée pour permettre l'adhésion sur un support 10, qui peut être avantageusement le support définitif (figure 2A).

La poignée 8 est ensuite éliminée par exemple par démontage au niveau de l'interface de collage 12 ou par élimination mécanique et/ou chimique (figure 2B).

Le collage des plaques entre elles peut être fait par exemple par collage par adhésion moléculaire ou au moyen d'une substance adhésive 7 (figure 1B - 1D), selon les spécifications de procédé ou de structures finales. Si une substance adhésive est employée, elle peut par la suite être éliminée.

La difficulté du collage des plaques avec circuits réside dans la présence d'une topologie en surface de la couche 5, c'est-à-dire de différences de niveaux e entre les zones élevées et les zones basses de cette surface, qui peuvent correspondre à plusieurs niveaux de métal dans des zones différentes ou, plus généralement, à des empilements différents de matériaux dans des zones différentes. Ces différences de niveaux peuvent atteindre une valeur de l'ordre de plusieurs µm, elles sont par exemple comprises entre 500 nm et 5 µm.

Un adhésif ou une substance adhésive peut être utilisé(e) pour coller les plaques entre elles. Dans ce cas, l'adhésif ou la substance adhésive peut être choisie avec une viscosité qui permet de coller sans être perturbé par la topologie de surface.

Dans le cas d'un collage par adhésion moléculaire, généralement, une couche 4 de matériau est déposée en surface (figure 1A).

Cette couche est ensuite aplanie puis collée sur la plaque intermédiaire ou le support final.

En l'absence d'une telle couche 4, des zones non collées peuvent être présentes au niveau de l'interface de collage et gêner le transfert de la couche mince.

Dans certains cas, notamment lors d'un double report, (permettant, comme expliqué en liaison avec les figures 2A et 2B, de remettre la surface traitée vers le haut sur la structure finale), la couche 4, utilisée pour l'adhésion doit être éliminée localement pour permettre la connexion sur les plots de contact.

Ceci est d'autant plus vrai dans le cas où, par exemple, la couche initiale 5 avec les circuits présente des plots de contact 6 initialement ouverts et qu'il est nécessaire qu'ils soient ré-ouverts après transfert (figure 3).

Après report de la couche traitée sur son support final, des opérations de lithographie et gravure sont donc effectuées pour ouvrir à nouveau les contacts 6.

Cependant, ces opérations supplémentaires de lithographie et gravure nécessitent la mise en oeuvre de moyens lourds.

Elles nécessitent également de disposer du ou des masques de lithographie correspondant aux niveaux à ouvrir, ce qui n'est pas toujours le cas.

En outre, dans certains cas, ces étapes ne sont pas compatibles avec le support définitif sur lequel doit être transféré le circuit.

Dans d'autres cas, on cherche, après l'étape de la figure 1D, à réaliser un traitement, directement de la couche 5, du côté de la surface 9, mais il se pose, en ce cas encore, le problème de retrouver, après traitement, la topologie de la couche 5 du côté opposé à la surface 9.

Dans d'autres cas encore, on cherche, après l'étape de la figure 1C, à réaliser un traitement, directement du support 1, par exemple après élimination partielle de celui - ci, mais il se pose, en ce cas encore, le problème de retrouver, après traitement, la topologie de la couche 5 du côté opposé à ce support 1.

Aussi, il se pose le problème de trouver un nouveau procédé permettant de faciliter la réalisation du report d'une couche pouvant contenir des circuits ou des composants et/ou pouvant présenter une topologie en surface.

De préférence, si la couche contient initialement des plots de contact en surface, on cherche à retrouver les plots de contact ouverts sans effectuer d'opération de lithographie.

Le document US 6 211 733 décrit un procédé pour la manipulation de matériaux en couches minces.

### EXPOSÉ DE L'INVENTION

L'invention a tout d'abord pour objet un procédé de préparation de la surface d'une couche mince ou d'une puce, cette couche mince ou cette puce présentant une topologie en surface, donc des variations d'altitude ou de niveau selon une direction perpendiculaire à un plan défini par la couche mince ou la puce, ce procédé comportant :
- la réalisation, au-dessus de la surface de ladite couche mince ou de ladite puce, d'au moins une couche, dite couche d'adhérence, et d'au moins une couche, dite première couche d'arrêt, entre la couche d'adhérence et la surface de ladite couche mince ou de ladite puce, la couche d'adhérence étant en un matériau dont la gravure présente une sélectivité par rapport au matériau de la couche d'arrêt.

La sélectivité du matériau de la couche d'adhérence par rapport au matériau de la couche d'arrêt signifie que la vitesse de gravure de la couche d'adhérence est supérieure à celle de la couche d'arrêt.

La couche mince ou la puce peut être supportée par une plaque support ou un substrat.

Les variations d'altitude de la topologie peuvent avoir une amplitude comprise entre quelques nm et plusieurs µm.

L'invention concerne également un procédé de transfert sur un substrat d'une couche mince ou d'une puce, cette couche mince ou cette puce étant supportée par une plaque support et présentant une topologie en surface, donc des variations d'altitude ou de niveau selon une direction perpendiculaire à un plan défini par la couche mince, ce procédé comportant :
- un procédé de préparation de la surface de ladite couche mince ou puce, tel est expliqué ci-dessus,
- le transfert de la couche mince ou de la puce sur ledit substrat,
- l'élimination des couches d'adhérence et de la première couche d'arrêt, pour retrouver la topologie initiale de la couche mince ou de la puce.

Le transfert peut comporter un assemblage préalable de la couche d'adhérence avec un substrat poignée, ainsi que l'élimination de tout ou partie de la plaque support.

Le substrat poignée peut ensuite être éliminé.

L'invention concerne également un procédé de traitement d'une couche mince ou d'une puce, cette couche mince ou cette puce étant supportée par une plaque support et présentant une topologie en surface, donc des variations d'altitude ou de niveau selon une direction perpendiculaire à un plan défini par la couche mince, ce procédé comportant :
- un procédé de préparation de la surface de ladite couche mince ou puce, tel que exposée ci-dessus,
- un assemblage de la couche d'adhérence avec un substrat poignée,
- une élimination de tout ou partie de la plaque support, puis :
   * un traitement de la couche mince ou de la puce à partir de sa face non assemblée avec ledit substrat poignée,
   * ou un traitement d'une face de la plaque support non assemblée avec la couche mince ou la puce,
- l'élimination du substrat poignée,
- l'élimination des couches d'adhérence et de la première couche d'arrêt, pour retrouver la topologie initiale de la couche mince ou de la puce.

Le traitement de la couche mince ou de la puce ou d'une face de la plaque support peut comporter une étape de dépôt d'une couche métallique et/ou de lithographie et/ou de gravure et/ou d'implantation ionique.

Le transfert sur ledit substrat et/ou assemblage avec un substrat poignée peut être réalisé par collage par adhérence moléculaire.

Une couche d'adhérence est par exemple une couche de matériau organique ou minéral qui permet l'adhérence entre deux surfaces grâce à ses propriétés de surface (rugosité, planéité, hydrophilie) dans le cas d'un collage par adhésion moléculaire ou grâce à la nature même de la couche dans le cas d'une substance adhésive.

La couche d'arrêt peut être en un matériau dont la gravure présente une sélectivité par rapport au matériau sous-jacent à cette couche d'arrêt.

Dans une variante, la première couche d'arrêt peut avoir une épaisseur comprise par exemple entre 10 nm et 500 nm et/ou conforme à la surface ou avoir une épaisseur supérieure à 500 nm et être conforme à la surface.

La surface de la couche mince ou de la puce peut comporter des zones de contact électrique.

La couche d'adhérence peut être par exemple de type minéral, comme par exemple en dioxyde de silicium, ou en nitrure de silicium, ou en polysilicium, ou de type organique, tel qu'un polymère de type BCB.

Le matériau de la première couche d'arrêt est de préférence choisi par rapport à la couche d'adhérence, de sorte que la gravure de la couche d'adhérence soit sélective par rapport à la couche d'arrêt. Ce peut être par exemple du nitrure (Si3N4) ou du silicium amorphe, le matériau de la couche d'adhérence étant de l'oxyde de silicium.

Selon un autre exemple, le matériau de la première couche d'arrêt peut être de l'oxyde (Si02) et le matériau de la couche d'adhérence du nitrure de silicium (Si3N4).

La couche mince ou la puce peut être directement sous-jacente à la couche d'arrêt.

Au moins une partie de la surface de la couche mince ou de la puce peut alors être en oxyde ou en oxynitrure ou en nitrure, cette partie pouvant correspondre à une couche de passivation. Une autre partie peut être par exemple en métal, tel que l'aluminium ou le cuivre, cette autre partie correspondant alors à des zones de contact.

Une deuxième couche d'arrêt, ou couche de protection, peut être présente entre la première couche d'arrêt et la surface de la couche mince ou de la puce.

Cette deuxième couche d'arrêt est choisie de sorte que la gravure de la première couche d'arrêt soit sélective par rapport à cette deuxième couche d'arrêt.

Cette deuxième couche d'arrêt peut être en un matériau dont la gravure présente une sélectivité par rapport au (x) matériau (x) en surface de la couche mince ou de la puce.

La présence de cette couche d'arrêt permet de protéger les matériaux de la surface à transférer, notamment dans le cas où ils sont attaqués plus rapidement que la première couche d'arrêt lors du retrait de cette dernière.

De façon avantageuse, deux couches d'arrêt permettent d'avoir une deuxième couche d'arrêt d'épaisseur plus fine que la première couche d'arrêt, elle sera donc plus facilement enlevée sans dégrader la couche mince ou la puce à transférer.

La deuxième couche d'arrêt a par exemple une épaisseur fine comprise entre 10 nm et 500 nm.

La deuxième couche d'arrêt peut être par exemple en oxyde de silicium (Si02).

Un procédé tel que décrit ci-dessus peut en outre comporter une étape de préparation de surface en vue d'un collage, par exemple une étape de planarisation de la couche d'adhérence.

L'invention concerne donc également un procédé de préparation de la surface d'une couche mince ou d'une puce, la surface de la couche mince (38) ou de la puce comportant au moins une couche de nitrure de silicium ou d'oxynitrure de silicium et des plots de contact métalliques, ce procédé comportant :
- la réalisation, au-dessus de la surface de ladite couche mince ou de ladite puce, d'au moins une couche, dite couche d'adhérence, en un matériau dont la gravure présente une sélectivité par rapport au matériau sous jacent.

La couche mince ou la puce peut être supportée par une plaque support. Elle peut présenter une topologie en surface, donc des variations d'altitude ou de niveau selon une direction perpendiculaire à un plan défini par la couche mince.

Un cas particulier est celui où la couche d'arrêt est constituée par le ou les matériau(x) en surface de la couche à transférer.

L'invention concerne également un procédé de transfert sur un substrat d'une couche mince ou d'une puce, cette couche mince ou cette puce étant supportée par une plaque support et présentant une topologie en surface, donc des variations d'altitude ou de niveau selon une direction perpendiculaire à un plan défini par la couche mince ou la puce, la surface de cette couche ou de cette puce comportant au moins une couche de nitrure de silicium (Si3N4) ou d'oxynitrure de silicium et des plots de contact métalliques, ce procédé de transfert comportant :
- un procédé de préparation de la surface de ladite couche mince ou puce, tel que exposée ci-dessus,
- le transfert de la couche mince ou de la puce sur ledit substrat,
- l'élimination de la couche d'adhérence pour retrouver la topologie initiale de la couche mince ou de la puce.

Le transfert peut comporter un assemblage préalable de la couche d'adhérence avec un substrat poignée ainsi que l'élimination de tout ou partie de la plaque support.

Un tel procédé peut en outre comporter, après transfert sur le substrat, ou après traitement, l'élimination du substrat poignée.

L'invention concerne également un procédé de traitement d'une couche mince ou d'une puce, cette couche mince ou cette puce étant supportée par une plaque support et présentant une topologie en surface, donc des variations d'altitude ou de niveau selon une direction perpendiculaire à un plan défini par la couche mince, la surface de cette couche ou de cette puce comportant au moins une couche de nitrure de silicium ou d'oxynitrure de silicium et des plots de contact métalliques, ce procédé de transfert comportant :
- un procédé de préparation de la surface de ladite couche mince ou puce, tel que exposée ci-dessus,
- un assemblage de la couche d'adhérence avec un substrat poignée,
- une élimination de tout ou partie de la plaque support, puis :
   * un traitement de la couche mince ou de la puce à partir de sa face non assemblée avec ledit substrat poignée,
   * ou un traitement d'une face de la plaque support non assemblée avec la couche mince ou la puce,
- l'élimination du substrat poignée,
- l'élimination de la couche d'adhérence, pour retrouver la topologie initiale.

Le traitement de la couche mince ou de la puce, ou d'une face de la plaque support, peut comporter une étape de dépôt d'une couche métallique et/ou de lithographie et/ou de gravure et/ou d'implantation ionique.

Le transfert sur ledit substrat et/ou l'assemblage avec un substrat poignée peut être réalisé par collage par adhérence moléculaire, ou réalisé à l'aide d'une substance adhésive.

La couche mince ou la puce peut, entre autres caractéristiques, avoir des plots de contact ouverts.

Cette application est particulièrement intéressante dans le cas où les plots de contact sont ouverts avant le transfert et qu'ils doivent être à nouveau ouverts après le transfert de la couche sur son support final. Dans ce cas, le procédé comporte en outre une étape d'élimination de la ou des couche(s) d'arrêt déposée(s) antérieurement.

### BRÈVE DESCRIPTION DES FIGURES

- Les figures 1A à 1D représentent des étapes d'un procédé connu de transfert simple,
- les figures 2A et 2B représentent les étapes d'un procédé connu de transfert double,
- la figure 3 représente une structure avec une couche comportant des circuits,
- les figures 4A et 4B représentent des étapes d'un procédé selon l'invention,
- les figures 5A - 5C représentent des étapes d'un deuxième procédé selon l'invention,
- la figure 6 illustre un troisième procédé selon l'invention,
- les figures 7A et 7B représentent des étapes d'un autre procédé selon l'invention,

### EXPOSÉ DÉTAILLÉ DE MODES DE RÉALISATION PARTICULIERS

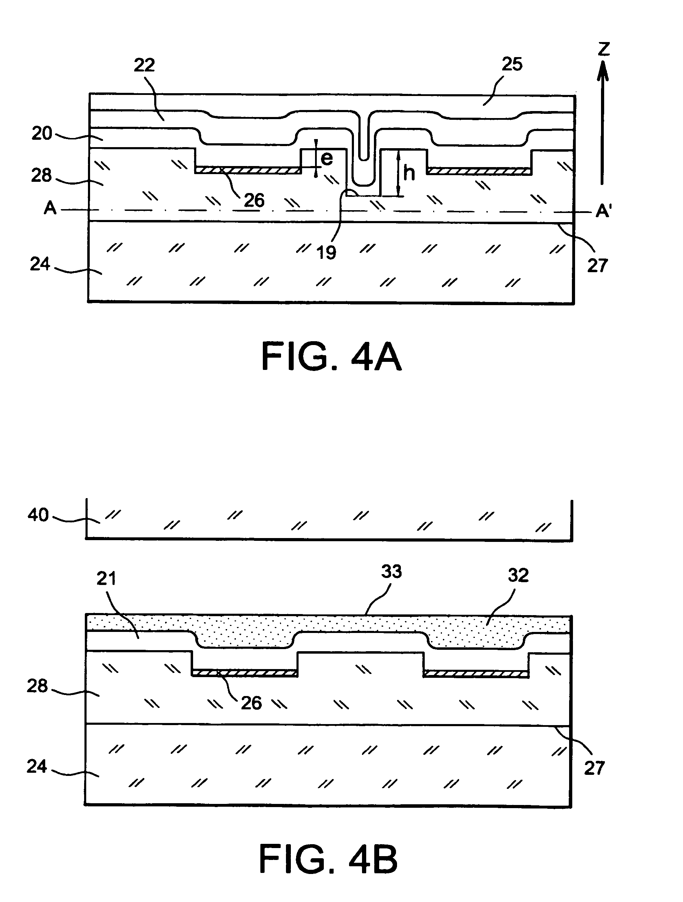

L'invention va d'abord être décrite en liaison avec la figure 4A.

Sur cette figure, une couche 28 est une couche contenant un ou des composants (non représentés sur la figure), ainsi que des plots de contact 26 de ces composants. Elle repose sur un substrat 24.

Le ou les composants peuvent être du type circuit électronique et/ou optique, et/ou de type microsystème, une ou des fonctionnalités du ou des composant(s) pouvant être commandées par des plots tels que les plots 26.

La couche contenant les composants et les plots de contact peut présenter une topologie en surface, c'est-à-dire des différences d'altitudes ou de niveaux entre les zones élevées et les zones basses de cette surface, qui correspondent par exemple à plusieurs niveaux de métal ou, plus généralement, à plusieurs niveaux dans des zones différentes dans lesquelles peuvent être empilés des matériaux différents (figure 4A).

Ces différences de niveaux peuvent atteindre une valeur (suivant une direction z perpendiculaire à un plan défini par la couche 28 et représenté par une trace AA' sur la figure 4A) de l'ordre de plusieurs µm, elles sont par exemple comprises entre quelques dizaines de nm et plusieurs µm, par exemple entre 10 nm ou 50 nm ou 500 nm et 1 µm ou 5 µm.

Il existe deux natures de différences de niveaux:
- le niveau e entre le haut de la surface, et le niveau des zones à ré-ouvrir (par exemple contact 26),
- et le niveau h entre le haut de la surface et le point le plus bas 19 de la surface (correspondant par exemple au fond des chemins de découpe), dont on peut chercher alors à tenir compte pour définir l'épaisseur de la couche d'adhérence qui permettra d'obtenir une bonne planarisation sur toute la surface.

L'invention s'applique également au cas où les surfaces sont homogènes, par exemple au cas d'une surface présentant des zones dont aucune n'est métallique, ces différentes zones présentant une topologie de surface, et donc des variations d'altitude comme expliqué ci-dessus, et en particulier dans les gammes indiquées ci-dessus.

Une première couche 20 est déposée à la surface de la plaque traitée 28.

Elle peut être désignée par l'expression « couche de protection » et/ou « deuxième couche d'arrêt » : elle est choisie de sorte qu'elle forme une couche d'arrêt au moment de la gravure de la couche superficielle 22 définie comme la première couche d'arrêt (voir ci-dessous). De façon avantageuse, cette couche 20 peut également être choisie de sorte, que lors de son retrait final (par exemple pour ouverture des plots 26 de contacts des composants après report sur le support final), les traitements de gravure (humide et/ou sèche, et/ou mécanique et/ou chimique) qui lui sont appliqués n'affectent pas ou très peu, les matériaux en surface de la couche 28 (dont, notamment, les métallisations au niveau des plots 26 de contact).

Dans une première variante, cette première couche 20 est constituée en un matériau différent de celui de la première couche d'arrêt et de ceux présents à la surface de la plaque traitée 28 de sorte que les traitements de gravure pour la retirer soient aussi peu contraignants que possible pour les matériaux de la surface de la couche 28, qui sont donc sous-jacents à la couche 20.

En d'autres termes, la couche 20 est en un matériau présentant les caractéristiques d'une couche d'arrêt par rapport à la première couche dite d'arrêt et dont la gravure est sélective par rapport au matériau constitutif de la plaque 28 : la gravure ou toute technique d'élimination de la couche 20 n'affecte la plaque 28 que de manière négligeable.

D'une manière générale, on appelle sélectivité le rapport entre les vitesses de gravure de deux matériaux, ici entre les matériaux des couches 20 et 28 (ou 22 et 20, 25 et 22 comme dans la suite). Par exemple la gravure d'une couche A présente une sélectivité par rapport à une autre couche B si le rapport entre les vitesses d'attaque (vitesse d'attaque de la couche A/ vitesse d'attaque de la couche B) est supérieur à 1.

On parle de forte sélectivité si ce rapport est supérieur à 10 ou compris entre 10 et 1000 ou même supérieur à 1000.

Pour un rapport des vitesses d'attaque entre 10 et 2, la sélectivité sera dite moyenne.

Si ce rapport est inférieur à 2, mais supérieur à 1, la sélectivité sera dite faible.

Dans les exemples donnés ci-dessus, on considérera le rapport de la vitesse d'attaque de la couche 20/vitesse d'attaque de la couche 28 ou de la vitesse d'attaque de la couche 22/vitesse d'attaque de la couche 20, pour déterminer si on est en présence d'une sélectivité élevée ou moyenne ou faible.

La sélectivité peut être choisie en fonction de la topologie e entre les zones hautes et les zones à ré-ouvrir. C'est par exemple le cas de la couche 25 dont l'attaque doit être sélective par rapport à la couche 22.

Le tableau I ci-dessous donne des exemples de vitesses d'attaque typiques pour quelques matériaux et quelques solutions d'attaque chimique :

| | SOLUTIONS D'ATTAQUE CHIMIQUE | | | |
|---|---|---|---|---|
| | TMAH 25% 80°C | HF 5% 20°C | HF 50% 20°C | H3PO4 160°C |
| Si | ∼500nm/min | <0.5nm/min | <1nm/min | ∼0.2nm/min |
| SiO2 | <0.5nm/min | 20-40nm/min | ∼500nm/min | <0.1nm/min |
| Si3N4 | <0.5nm/min | ∼0.8nm/min | <20nm/min | ∼5nm/min |

Dans une deuxième variante, la couche de protection est identique à une partie de la surface de la couche 28 (par exemple à une partie de passivation), elle constitue donc une surépaisseur qui pourra être enlevée, elle est par exemple en SiO₂.

D'une manière générale, une surgravure de la couche 20 est également possible. On peut surgraver la couche 20 et ainsi attaquer un peu la couche 28 sans attaquer le métal 26.

Pour une plaque 28 en oxynitrure ou nitrure silicium avec des contacts en aluminium, la couche 20 est par exemple en dioxyde de silicium (SiO₂).

Cette couche 20 peut en outre avoir une épaisseur faible, par exemple comprise entre 10 nm et 500 nm de manière à encore mieux contrôler tout traitement de gravure de cette couche 20.

Cette épaisseur limitée, comprise entre 10 nm et 500 nm, peut être aussi suffisante pour contrôler la gravure de la couche 20, même si le matériau dont elle est constituée est d'une nature assez voisine du matériau présent en surface de la couche 28. Par exemple la couche 20 peut être une couche de Si02 d'épaisseur comprise entre 10 nm et 100 nm, par exemple 50 nm, alors même que la superficie de la couche 28 est elle aussi en SiO2.

Une deuxième couche 22 constitue une couche dite « couche d'arrêt », appelée première couche d'arrêt, vis-à-vis d'une troisième couche 25, elle-même choisie pour ses qualités de collage ou d'adhérence.

Les propriétés de gravure de la couche 22 sont différentes de celles de la première couche 20, de sorte que la couche 22 peut être ultérieurement éliminée par gravure, sans que la couche 20 soit affectée, ou seulement de manière superficielle. Il peut même y avoir surgravure, c'est-à-dire que la couche 20 peut être un peu attaquée par la gravure de la couche 22, sans pour autant disparaître, même localement.

Autrement dit, la couche 22 est choisie de sorte que, lors de son retrait final les traitements de gravure (humide et/ou sèche, et/ou mécanique et/ou chimique) n'affectent pas, ou peu, le matériau en surface de la couche 20, sous-jacent à la couche 22, ou soient aussi peu contraignants que possible pour ce matériau sous-jacent de cette couche 20.

Encore en d'autres termes, la couche 22 est en un matériau dont la gravure présente une sélectivité, par exemple au moins >1,5, au sens déjà expliqué ci-dessus, par rapport au matériau constitutif de la couche 20 : la gravure ou toute technique d'élimination de la couche 22 n'affecte la couche 20 que de manière négligeable l'affecte un peu mais pas totalement.

La couche 25 est choisie pour ses qualités de collage. C'est par exemple une couche permettant un collage par adhésion moléculaire, par exemple une couche en SiO2. Ces propriétés d'adhésion peuvent être renforcées par préparation de l'état de surface de cette couche, par exemple par polissage mécano-chimique, ou par nettoyage chimique et/ou mécanique.

L'épaisseur de cette couche est de préférence fonction de h, c'est-à-dire de la topologie initiale des plaques. L'épaisseur est par exemple 2 x h pour obtenir une bonne planarisation et un collage homogène.

L'épaisseur de la première couche d'arrêt est, quant à elle, de préférence choisie en fonction de la sélectivité entre la couche de collage et la première couche d'arrêt, mais aussi de préférence en fonction de e et de l'épaisseur moyenne de la couche d'adhérence.

Lors de l'élimination de cette couche 25 d'adhérence, la couche 22 n'est pas ou peu affectée.

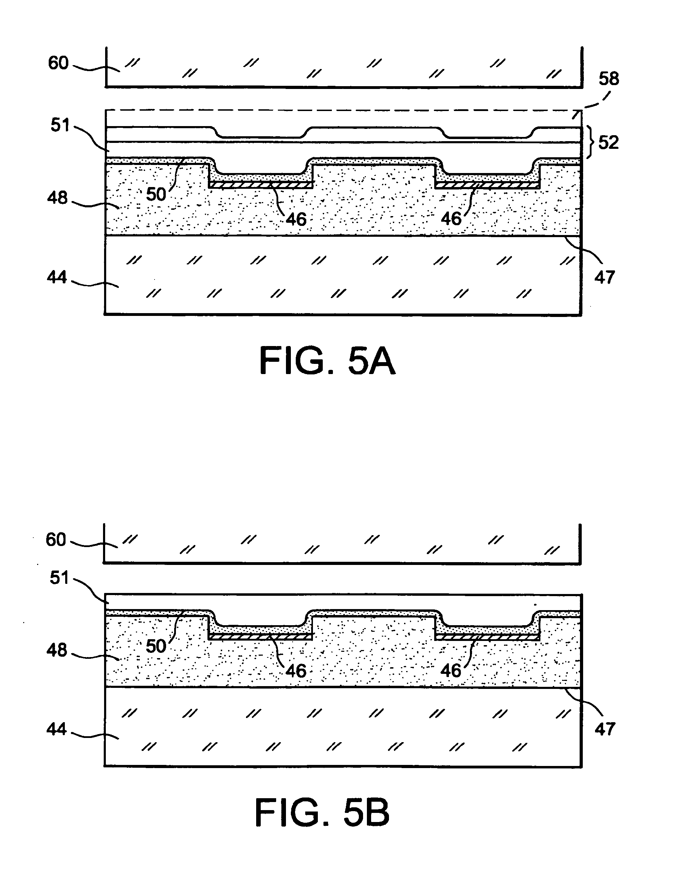

Selon un exemple, la couche 22 est en nitrure de silicium, sur une fine couche 20 de Si02 (épaisseur de 10 nm à 100 nm), la couche de collage 25 étant en SiO2 et la couche mince 28 également en SiO2 avec des plots en aluminium par exemple. Cet exemple sera expliqué plus en détail ci-dessous, en liaison avec les figures 5A - 5C.

Selon un autre mode de réalisation de l'invention, illustré en figure 4B, on peut déposer une première couche 21 à la surface de la couche 28 (correspondant à la première couche d'arrêt).

C'est par exemple une couche 21 de nitrure de silicium Si3N4, d'épaisseur comprise entre 10 nm et 100 nm.

Ensuite, une deuxième couche 32 d'un deuxième matériau peut être déposée. Il s'agit d'une couche de collage. Ce deuxième matériau n'a pas les mêmes propriétés physiques que le matériau de la couche 21, cette dernière jouant le rôle de couche d'arrêt par rapport à toute solution d'attaque chimique de la couche 32.

Les propriétés de gravure de la couche 32 sont donc différentes de celles de la première couche d'arrêt 21, de sorte que la couche 32 peut être ultérieurement éliminée par gravure, sans que la couche 20 soit affectée, ou seulement de manière superficielle.

Autrement dit, la couche 32 est choisie de sorte que, lors de son retrait final les traitements de gravure (humide ou sèche et/ou chimique ou mécano-chimique) n'affectent pas, ou peu, le matériau sous-jacent, en surface de la couche 21, ou soient aussi peu contraignants que possible pour le matériau sous-jacent de cette couche 21.

En d'autres termes, la couche 32 est en un matériau dont la gravure présente une sélectivité, au sens déjà expliqué ci-dessus, par rapport au matériau constitutif de la couche 21 : la gravure ou toute technique d'élimination de la couche 32 n'affecte la couche 21 que de manière négligeable. Il peut même y avoir surgravure, c'est-à-dire que la couche 21 peut être un peu attaquée par la gravure de la couche 32, sans pour autant disparaître, même localement.

Cette deuxième couche 32 est par exemple en SiO2 (oxyde). Ce peut être aussi une substance adhésive de type polymère (résine, BCB...).

Si les caractéristiques des couches déposées 21, 32 ne sont pas compatibles avec un collage direct par adhésion moléculaire (ce qui est le cas si la planarisation est insuffisante, et/ou si la rugosité de surface est élevée...), on pourra réaliser une étape de planarisation mécano-chimique, suivie d'un nettoyage, de la surface 33 avant collage de la plaque traitée sur un substrat 40, par exemple une poignée intermédiaire.

Selon cet autre mode de réalisation, la sélectivité de la gravure de la couche 32 par rapport à la couche 21 permet d'éliminer, par la suite, cette couche 32 sans attaquer la couche 21, puis de graver, dans une deuxième étape, cette couche 21, dont la nature et/ou l'épaisseur limitée assure(nt) le contrôle de la gravure. Il n'y a alors aucun risque d'endommager la plaque 28.

Selon un autre exemple, la couche 21 est en silicium amorphe et la couche 32 en dioxyde de silicium, pour une couche 28 en oxyde de silicium, ou en oxynitrure de silicium, ou en nitrure de silicium. La couche 21 joue alors le rôle de couche d'arrêt, et encore le rôle de couche de protection lors de la gravure ultérieure de la couche d'adhérence 32.

Selon un exemple de réalisation de l'invention, illustré en figure 5A - 5C, on peut déposer successivement une couche 50, dite couche de protection, et deuxième couche d'arrêt, par exemple en SiO2, de faible épaisseur (comprise entre, par exemple, 50 nm et 100 nm), puis une couche 52 d'arrêt en nitrure (Si3N4), et ce même si la surface de plaque 48 est également en Si02.

La sélectivité de la gravure du Si3N4 par rapport au SiO2 est telle qu'il est possible de graver la couche 52 sans trop attaquer la fine couche d'oxyde 50.

Cette dernière étant de faible épaisseur, elle peut être aisément enlevée de manière contrôlable, sans risque, ou avec un très faible risque, d'attaque de la plaque 48 ou des plots métalliques 46.

La couche 52 peut être planarisée, pour ne laisser subsister qu'une partie appelée sous-couche 51 à surface plane (figure 5B).

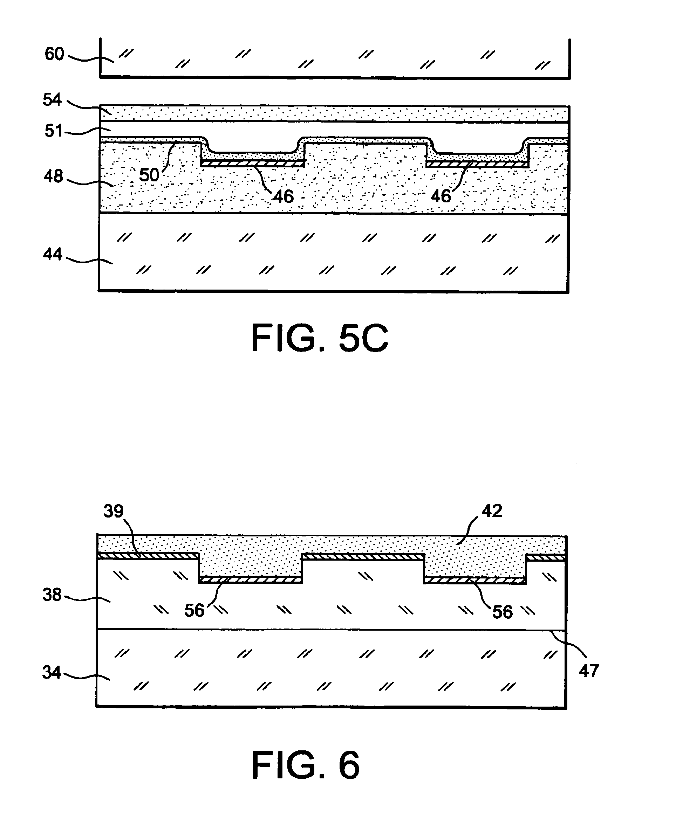

Eventuellement, afin de renforcer le collage sur un autre substrat 60, par exemple un substrat poignée, une couche supplémentaire 54 de collage, ou favorisant l'adhérence, notamment en vue d'une adhésion moléculaire, par exemple une couche de SiO2, peut être ajoutée sur la sous-couche 51 (figure 5C).

Une couche supplémentaire 58 de collage, par exemple une couche de SiO2, peut aussi être directement ajoutée sur la couche 52 non planarisée (comme illustré sur la figure 5A), afin de préparer, et notamment de réaliser une planarisation de l'ensemble en vue du collage, notamment en vue d'une adhésion moléculaire, avec un substrat 60.

Une telle couche supplémentaire 54 ou 58 permet de limiter l'épaisseur de la couche 51 ou 52 et de n'avoir par la suite à éliminer, par exemple par gravure, qu'une épaisseur limitée de cette couche 51 ou 52. Cette opération ultérieure peut ainsi être faite de manière très bien contrôlée, sans aucun risque d'endommager ni la couche 50 ni ou la plaque 48.

L'utilisation d'une troisième couche 54, 58 peut donc notamment présenter un intérêt lorsque la sélectivité d'attaque chimique n'est pas suffisante entre les deux premières couches 50 et 51, ou si la planisation de la deuxième couche n'est pas suffisante en vue d'une adhésion moléculaire.

Cette variante peut également être avantageuse dans le cas où la deuxième couche 52 déposée est elle-même peu apte à un collage.

Comme déjà expliqué ci-dessus, la couche supplémentaire 54, 58 de collage présente elle-même des propriétés de gravure qui lui permettent d'être éliminée sélectivement par rapport à la couche 51, 52, cette dernière jouant alors le rôle de couche d'arrêt lors de l'étape de gravure.

Ensuite, la structure est collée sur une autre plaque 40 ou 60, par exemple une plaque poignée. La technique de collage peut être notamment un collage par adhésion moléculaire (cas de la figure 5B) ou au moyen d'une substance adhésive telle que la couche 25, 32 des figures 4A ou 4B ou la couche 54,58 des figures 5A ou 5C.

Un traitement thermique peut être réalisé de façon à renforcer les forces de collage.

Le substrat 24 ou 44 portant la couche mince à transférer est ensuite éliminé par exemple par des moyens mécaniques et/ou chimiques, par exemple par rectification, polissage mécano-chimique ou attaque chimique TMAH.

La face arrière amincie 27 ou 47 de la couche processée 28 ou 48, collée sur sa poignée 40 ou 60, est ensuite préparée de façon à être solidarisée sur son support final.

Les moyens de préparation peuvent être choisis par exemple parmi un polissage mécano-chimique, un nettoyage chimique, mécanique.

Après collage de cette face arrière 27 ou 47 sur le support définitif (par exemple tel qu'un support en verre ou en silice ou en saphir ou un support choisi pour ses propriétés thermiques ou électriques (isolant ou conducteur) ou optiques ou un substrat semiconducteur, traité ou pas, contenant ou pas, tout ou partie d'un composant électronique et/ou optique et/ou mécanique), par exemple par adhésion moléculaire, ou au moyen d'une substance adhésive (colle, résine,...), la poignée 40 ou 60 peut être éliminée.

Pour consolider le collage, certains traitements postérieurs peuvent être réalisés comme un traitement thermique.

L'élimination de la poignée 40,60 peut se faire par les mêmes moyens que ceux utilisés pour éliminer tout ou partie du substrat initial 24,44 ou par des moyens permettant le démontage de la poignée.

De façon préférentielle, ce démontage peut être fait au niveau de l'interface de collage entre le substrat poignée 40,60 et la surface de la couche mince 28,48 à transférer.

Ensuite, une fois cette couche 28,48 transférée, les couches 20, 21, 22, 25, 32, 50, 51, 52, 54, 58 qui ont été déposées en surface sont éliminées progressivement par différents moyens comme par exemple des attaques plasma et/ou des attaques chimiques en phase liquide ou en phase gazeuse, et/ou des attaques ioniques, et/ou des gravures et/ou des polissages mécano-chimique.

L'intérêt d'avoir un dépôt multi-couche est que l'on peut graver successivement, et individuellement et de manière contrôlée, les différentes couches sans induire de dégradation des contacts 26,46 et de la surface de la plaque 28,48, protégés par la première couche déposée 20, 21, 50. Celle-ci sera finalement éliminée sans affecter la surface de la couche 48, comme déjà expliqué ci-dessus.

Selon encore un autre exemple d'application illustré sur la figure 6, le substrat 38 à transférer comporte, en superficie, une couche 39 de nitrure de silicium (Si3N4) ou d'oxynitrure de silicium et/ou des plots de contact 56 métalliques, par exemple en cuivre ou en aluminium.

Une couche 42 de collage qui, dans le cas d'une adhérence moléculaire, est par exemple en dioxyde de silicium SiO2 ou, dans le cas d'une couche adhésive, en polymère BCB, est formée directement sur la plaque 38.

Plus généralement, on peut former, sur un substrat 38 à transférer, une couche 42 en un matériau présentant, lors de sa gravure, une sélectivité par rapport aux matériaux 39, 56 en surface de la couche 38, ce qui permet d'assurer une élimination de cette couche d'adhérence 42 sans risque, ni pour la plaque 38, donc ni pour le matériau 39, ni pour les contacts 56.

Il est ensuite procédé à un transfert comme déjà décrit ci-dessus, par exemple d'abord sur un substrat poignée, puis sur un substrat définitif dans le cas d'un double report.

Il est alors possible d'éliminer la couche 42, par gravure et sans risque ni pour la surface 39 ni pour les plots 56.

L'invention concerne donc également un procédé de transfert de couches minces, notamment du type contenant une forte topologie, à retrouver après un transfert, ce procédé comportant :
a) la réalisation d'une couche d'adhérence ou d'un empilement de plusieurs couches, dites couches d'arrêt, tel que décrit ci-dessus, à la surface de la couche mince,
b) le collage de la couche d'adhérence ou de l'empilement, et donc de la couche mince, sur une plaque support (telle que par exemple la plaque 40, 60 des figures 4B - 5C).

Si cette plaque support est temporaire, le procédé peut en outre comporter :
- l'élimination de tout ou partie de la zone arrière d'une plaque (telle que par exemple la plaque 24, 34, 44 des figures 4A - 6) supportant la couche mince avec la forte topologie,
- le collage de la face arrière de la couche mince sur un support final,
- l'élimination de la plaque support temporaire,
- l'élimination de la couche d'adhérence ou de l'empilement multi-couches pour retrouver la topologie initiale, ce que permettent les propriétés de la couche d'adhérence ou de l'empilement, réalisés conformément à l'invention selon l'un des modes de réalisation exposés ci-dessus en liaison avec les figures 4A-6.

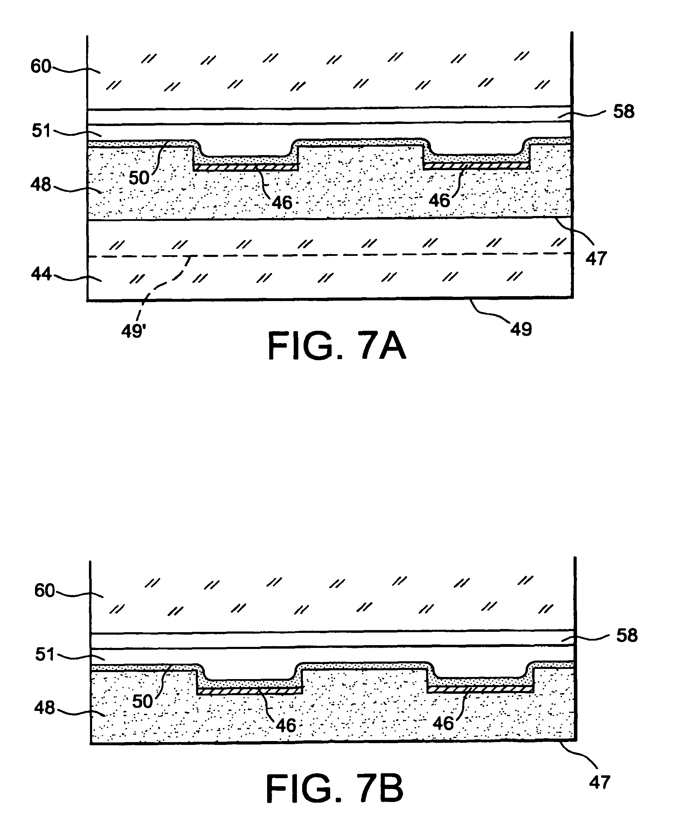

Dans une variante, et toujours dans l'hypothèse où la plaque support est temporaire, le procédé peut en outre comporter, après les étapes a) et b) ci-dessus :
- un traitement de la surface 49 d'une plaque supportant la couche mince avec la forte topologie ; ce cas est représenté en figure 7A, où les références sont reprises de la figure 5A et où le support 60 est représenté assemblé avec l'ensemble formé du substrat 44, de la puce 48 et de l'empilement 50-51, et où le traitement sera celui de la plaque 44, à partir de sa surface 49. Le traitement peut aussi être réalisé à partir d'une surface 49' après élimination partielle du substrat 44; le traitement peut par exemple comporter une étape de dépôt d'une couche métallique et/ou une ou plusieurs étapes de lithographie/gravure et/ou une ou plusieurs étapes d'implantation ionique et/ou de nettoyage et/ou d'amincissement;
- ou une élimination de cette plaque 44 supportant la couche mince ou de la puce 48 et un traitement de cette couche mince ou de cette puce ; ce cas est représenté en figure 7B, avec les mêmes notations que la figure 7A ; le support 44 est éliminé et la puce peut être traitée à partir de sa surface 47.

On peut ensuite procéder à l'élimination de la plaque support temporaire 60, puis de l'empilement multi couche 50-51.

Dans les divers cas exposés ci-dessus, , l'empilement de multi-couches sera de préférence tel qu'il permette l'obtention d'une surface plane compatible avec un collage par adhésion moléculaire sur une plaque support, notamment intermédiaire, telle que la plaque 60.

De plus, comme expliqué ci-dessus, les couches de l'empilement sont choisies du fait de leurs propriétés de gravure différentes, une couche inférieure servant de couche d'arrêt lors de l'élimination de la couche immédiatement supérieure.

Une telle mise en oeuvre facilite le retrait final des couches pour retrouver les contacts.

L'empilement multi-couche peut comporter au moins une couche de nitrure de silicium en tant que couche d'arrêt.

La couche d'adhérence peut être par exemple une couche d'oxyde de silicium.

Les procédés selon l'invention s'applique également dans le cas du transfert d'objet de petites dimensions comme par exemple des « puces ».

Dans les procédés décrits ci-dessus, les couches d'adhérence ou intermédiaires peuvent être obtenues par dépôt de type PECVD ou LPCVD.

Un exemple de réalisation concerne une plaque (par exemple sur un substrat SOI) processée, des composants ou circuits se trouvant dans la couche mince de Si superficielle comportant des zones de contact ouvert (en aluminium : A1) et des zones de passivation (en nitrure de silicium : SiN). La topologie maximale h mesurée à la surface de cette plaque est par exemple de 2 µm (entre les zones les plus hautes et les zones les plus basses, par exemple au niveau des chemins de découpe). Comme déjà indiqué ci-dessus, on choisit de préférence l'épaisseur de la couche d'adhésion en fonction de h pour l'obtention d'une bonne planarisation et d'un collage homogène sur toute la surface.

La différence d'amplitude e entre les zones les plus hautes et les zones de contact à ré-ouvrir peut être différente de h. par exemple, considérons ici qu'elle est de 1 µm.

Selon le schéma de la figure 4A, on pourra former, selon un mode de réalisation de l'invention, un empilement de type :
- couche 20 dite « de protection » (sur la surface processée) : en SiO2 TEOS, ou Tétraéthyl-Orthosilicate, obtenu par exemple par PECVD, d'épaisseur 50 nm,
- couche 22 dite « d'arrêt » (sur la couche 20) : en SiN, obtenu par exemple par PECVD, d'épaisseur 500 nm,
- couche 25 dite « d'adhésion » (sur la couche 22) : en SiO2 TEOS, pouvant elle aussi être obtenue par PEVCD, d'épaisseur 4 µm.

La couche 25 est ensuite planarisée et nettoyée pour être collée sur un substrat poignée. Un traitement thermique à basse température (par exemple 200°C) pourra être avantageusement effectué afin de consolider l'interface de collage. La face arrière 24 de la plaque processée pourra être amincie par rectification mécanique puis gravure chimique jusqu'à la couche d'oxyde enterrée du substrat SOI. La surface de cet oxyde est alors préparée et collée sur un substrat de silice fondue. Un traitement thermique de consolidation pourra être fait par exemple à 200°C. Le substrat « poignée » sera ensuite éliminé (par exemple par rectification mécanique et gravure chimique).

On retrouve alors, en surface, la couche 25 planarisée, la couche 22, la couche 20 et enfin la surface initiale de la plaque avec des zones de contact ouvert et des zones de passivation. La couche 25 (dite « d'adhésion » peut être éliminée par chimie (par exemple par traitement HF à 25% et/ou BOE 30/1). Rappelons que l'objectif est ici d'éliminer la couche d'adhésion jusqu'au niveau des zones de contact (niveau e), pas nécessairement jusqu'au niveau le plus bas de la topologie (niveau h : par exemple les chemins de découpe). La couche 22 fait alors office de couche d'arrêt pour le retrait de la couche 25 (sélectivité de l'ordre de 3 à 5): elle pourra être légèrement attaquée lors de cette étape (par exemple sur environ 200 nm). La couche 22 (qui est de préférence conforme à la surface initiale) peut ensuite être éliminée par attaque au H3PO4 (à 160°C) ; la couche 20 dite « de protection » joue le rôle de couche d'arrêt (sélectivité ∼10) lors du retrait de la couche 22 et de couche de protection par rapport aux matériaux sous-jacents (la couche processée). Enfin, la couche 20 (conforme à la surface) est retirée par immersion rapide dans un bain chimique (par exemple BOE (« Buffered Oxide Etch ») 30/1) ou par gravure plasma.

Un autre exemple concerne une plaque (par exemple substrat Si bulk ou massif) processée comportant des zones de contact ouvert (cuivre : Cu) et des zones de passivation (oxyde de silicium : SiO2). La topologie maximale h mesurée à la surface de cette plaque est par exemple de 3 µm (entre les zones les plus hautes et les zones les plus basses, par exemple les chemins de découpe). La différence d'amplitude e entre les zones les plus hautes et les zones de contact à ré-ouvrir peut être différente de h, par exemple, considérons ici qu'elle est de 500 nm.

On pourra ainsi former, selon un autre mode de réalisation de l'invention, un empilement du type de celui de la figure 4B :
- couche 21 dite « de protection et d'arrêt » (sur la surface processée) : en SiN, l'épaisseur 200 nm,
- couche 32 dite « d'adhésion » (sur la couche 21) : en SiO2, TEOS, par exemple obtenue par PECVD, d'épaisseur 5 µm.

La couche 32 sera ensuite planarisée et nettoyée pour être collée sur une poignée. Un traitement thermique à basse température (par exemple 300°C) pourra être avantageusement effectué afin de consolider l'interface de collage. La face arrière 24 de la plaque processée 28 pourra ensuite être amincie par rectification mécanique puis polissage mécano-chimique jusqu'à une épaisseur finale de la couche transférée de 6 µm. La surface 27 du substrat 28 en Si est alors préparée et collée sur un substrat de silice fondue. Un traitement thermique de consolidation pourra être fait par exemple à 200°C. Le substrat 40 « poignée » sera ensuite éliminé (par exemple par traitement par rectification mécanique et gravure chimique).

On retrouve alors, en surface, la couche 32 planarisée, la couche 21 et enfin la surface initiale de la plaque avec des zones de contact ouvert et des zones de passivation. La couche 32 (dite « d'adhésion » peut être éliminée par chimie (par exemple par traitement HF à 50% et/ou BOE 30/1). Rappelons que l'objectif ici est d'éliminer la couche d'adhésion jusqu'au niveau des zones de contact (niveau e) et pas nécessairement jusqu'au niveau le plus bas de la topologie. La couche 21 fait alors office de couche d'arrêt (sélectivité de l'ordre de 3 à 5) pour le retrait de la couche 32 : elle pourra être légèrement attaquée lors de cette étape (sur par exemple environ 120 nm). La couche 21 (qui est conforme à a la surface initiale) peut ensuite être éliminée par gravure sèche : la sélectivité de certains procédés peut être >10 par rapport aux matériaux sous-jacents (couche processée : ici Cu et Si02).

Enfin, le tableau II ci-dessous donne quelques exemples de combinaisons possibles de matériaux dans le cas d'une structure telle que celle de la figure 4A.

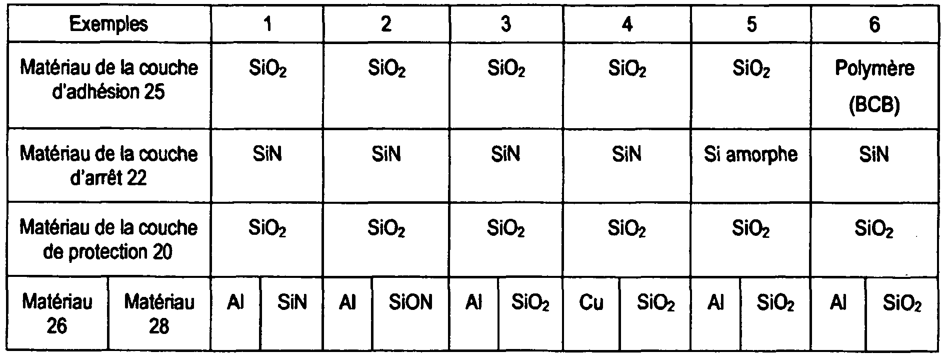

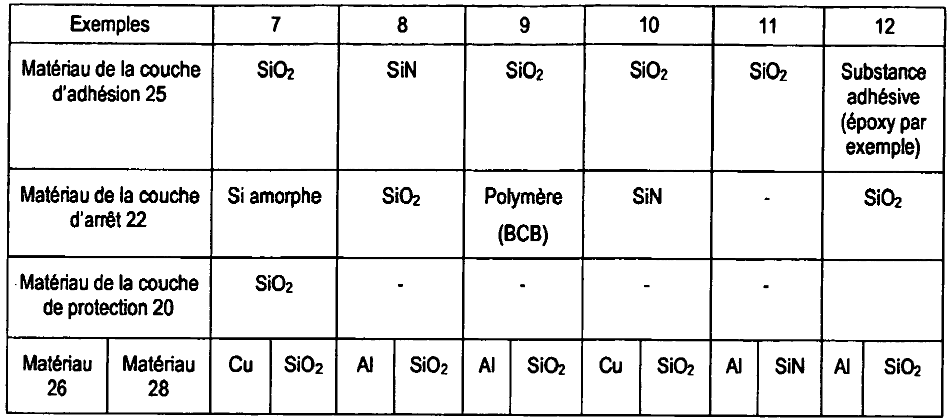

## Revendications

1. Procédé de préparation de la surface d'une couche mince (28, 38, 48) ou d'une puce, cette couche mince ou cette puce présentant une topologie en surface, donc des variations d'altitude ou de niveau selon une direction perpendiculaire à un plan défini par la couche mince, ce procédé comportant:
- la réalisation, au-dessus de la surface de ladite couche mince ou de ladite puce, d'au moins une couche, dite couche d'adhérence (22, 24, 32, 58, 54, 42), et d'au moins une couche, dite première couche d'arrêt (20, 21, 51, 52), entre la couche d'adhérence et la surface de ladite couche mince ou de ladite puce, la couche d'adhérence étant en un matériau dont la gravure présente une sélectivité par rapport au matériau de la couche d'arrêt.

2. Procédé de transfert sur un substrat d'une couche mince (28, 38, 48) ou d'une puce, cette couche mince ou cette puce étant supportée par une plaque support (24, 34) et présentant une topologie en surface, donc des variations d'altitude ou de niveau selon une direction perpendiculaire à un plan défini par la couche mince, ce procédé comportant :
- un procédé de préparation de la surface de ladite couche mince (28, 38, 48) ou puce selon la revendication 1,
- le transfert de la couche mince ou de la puce sur ledit substrat,
- l'élimination des couches d'adhérence et de la première couche d'arrêt, pour retrouver la topologie initiale de la couche mince ou de la puce.

3. Procédé selon la revendication 2, le transfert comportant un assemblage préalable de la couche d'adhérence avec un substrat poignée (40, 60), ainsi que l'élimination de tout ou partie de la plaque support.

4. Procédé selon la revendication 3, comportant en outre, l'élimination du substrat poignée.

5. Procédé de traitement d'une couche mince (28, 38, 48) ou d'une puce, cette couche mince ou cette puce étant supportée par une plaque support (24, 34) et présentant une topologie en surface, donc des variations d'altitude ou de niveau selon une direction perpendiculaire à un plan défini par la couche mince, ce procédé comportant :
- un procédé de préparation de la surface de ladite couche mince (28, 38, 48) ou puce selon la revendication 1,
- un assemblage de la couche d'adhérence avec un substrat poignée (40, 60),
- une élimination de tout ou partie de la plaque support, puis :
* un traitement de la couche mince ou de la puce à partir de sa face (47) non assemblée avec ledit substrat poignée,
* ou un traitement d'une face (49, 49') de la plaque support non assemblée avec la couche mince ou la puce,
- l'élimination du substrat poignée,
- l'élimination des couches d'adhérence et de la première couche d'arrêt, pour retrouver la topologic initiale de la couche mince ou de la puce.

6. Procédé selon la revendication 5, le traitement de la couche mince ou de la puce ou d'une face de la plaque support comportant une étape de dépôt d'une couche métallique et/ou de lithographie et/ou de gravure et/ou d'implantation ionique et/ou de nettoyage et/ou d'amincissement.

7. Procédé selon l'une des revendications 2 à 6, le transfert sur ledit substrat et/ou l'assemblage avec un substrat poignée étant réalisé par collage par adhérence moléculaire.

8. Procédé selon l'une des revendications 2 à 7, la première couche d'arrêt étant en un matériau dont la gravure présente une sélectivité par rapport au matériau sous-jacent à cette couche d'arrêt.

9. Procédé selon l'une des revendications 2 à 8, la première couche d'arrêt ayant une épaisseur comprise entre 10 run et 500 nm et/ou conforme à la surface de ladite couche mince ou de ladite puce ou a une épaisseur supérieure à 500 nm et est conforme à la surface de ladite couche mince ou de ladite puce.

10. Procédé selon l'une des revendications 2 à 9, la ou les variations de niveau étant comprise(s) entre 10 nm et 5 µm.

11. Procédé selon l'une des revendications 2 à 10, la surface de la couche mince ou de la puce comportant des zones (24, 46) de contact électrique.

12. Procédé selon l'une des revendications 2 à 11, la couche d'adhérence (42) étant de type minéral.

13. Procédé selon la revendication 12, la couche d'adhérence étant en dioxyde de silicium.

14. Procédé selon l'une des revendications 2 à 11, la couche d'adhérence étant de type organique.

15. Procédé selon la revendication 14, la couche d'adhérence étant en polymère de type BCB, ou une substance adhésive.

16. Procédé selon l'une des revendications 2 à 15, le matériau de la première couche d'arrêt (22) étant du nitrure (Si3N4) ou du silicium amorphe et le matériau de la couche d'adhérence (32) de l'oxyde de silicium (SiO2).

17. Procédé selon l'une des revendications 2 à 15, le matériau de la première couche d'arrêt (22) étant de l'oxyde (SiO2) et le matériau de la couche d'adhérence (32) du nitrure de silicium (Si3N4).

18. Procédé selon l'une des revendications 2 à 17, la couche mince (38) ou la puce étant directement sous-jacente à la couche d'arrêt.

19. Procédé selon la revendication 18, au moins une partie (39) de la surface de la couche mince ou de la puce étant en un oxyde ou en un oxynitrure ou en un nitrure.

20. Procédé selon la revendication 19, au moins une autre partie de la surface de la couche mince ou de la puce comportant des zones de contact.

21. Procédé selon l'une des revendications 2 à 20, une deuxième couche d'arrêt (20), ou couche de protection, étant présente entre la première couche d'arrêt (22) et la surface de la couche mince ou de la puce.

22. Procédé selon la revendication 21, cette deuxième couche d'arrêt (20) étant en un matériau dont la gravure présente une sélectivité par rapport au matériau en surface de la couche mince ou de la puce.

23. Procédé selon l'une des revendications 21 ou 22, la deuxième couche (20) d'arrêt ayant une épaisseur comprise entre 10 nm et 500 nm.

24. Procédé selon l'une des revendications 21 à 23, la deuxième couche d'arrêt étant en oxyde de silicium (SiO2).

25. Procédé selon l'une des revendications 2 à 24, comportant en outre une étape de préparation de surface en vue d'un collage.

26. Procédé de préparation de la surface d'une couche mince (28, 38, 48) ou d'une puce, , la surface de la couche mince (38) ou de la puce comportant au moins une couche de nitrure de silicium (Si3N4) ou d'oxynitrure de silicium et des plots (56) de contact métalliques, ce procédé comportant:
- la réalisation, au-dessus de la surface de ladite couche mince ou de ladite puce, d'au moins une couche, dite couche d'adhérence (22, 24, 32, 58, 54, 42), en un matériau dont la gravure présente une sélectivité par rapport au matériau sous jacent.

27. Procédé de transfert sur un substrat d'une couche mince (38) ou d'une puce, cette couche mince ou cette puce étant supportée par une plaque support (24, 34) et présentant une topologie en surface, donc des variations d'altitude ou de niveau selon une direction perpendiculaire à un plan défini par la couche mince, la surface de la couche mince (38) ou de la puce comportant au moins une couche de nitrure de silicium (Si3N4) ou d'oxynitrure de silicium et des plots (56) de contact métalliques, ce procédé comportant :
- un procédé de préparation de la surface de la couche mince ou de la puce, selon la revendication 26,
- le transfert de la couche mince ou de la puce sur ledit substrat,
- l'élimination de la couche d'adhérente pour retrouver la topologie initiale de la couche mince ou de la puce.

28. Procédé selon la revendication 27, le transfert comportant un assemblage préalable de la couche d'adhérence avec un substrat poignée (40, 60), ainsi que l'élimination de tout ou partie de la plaque support.

29. Procédé selon la revendication 28, comportant, après transfert sur le substrat, l'élimination du substrat poignée.

30. Procédé de traitement d'une couche mince (38) ou d'une puce, cette couche mince ou cette puce étant supportée par une plaque support (24, 34) et présentant une topologie en surface, donc des variations d'altitude ou de niveaux selon une direction perpendiculaire à un plan défini par la couche mince, la surface de la couche mince (38) ou de la puce comportant au moins une couche de nitrure de silicium (Si3N4) ou d'oxynitrure de silicium et des plots (56) de contact métalliques, ce procédé comportant :
- un procédé de préparation de la surface de la couche mince ou de la puce selon la revendication 26,
- un assemblage de la couche d'adhérence avec un substrat poignée (40, 60),
- une élimination de tout ou partie de la plaque support puis :
* un traitement de la couche mince ou de la puce à partir de sa face (47) non assemblée avec ledit substrat poignée,
* ou un traitement d'une face (49, 49') de la plaque support non assemblée avec la couche mince ou la puce,
- l'élimination du substrat poignée,
- l'élimination de la couche d'adhérence, pour retrouver la topologie initiale de la couche mince ou de la puce.

31. Procédé selon la revendication 30, le traitement de la couche mince ou de la puce, ou d'une face de la plaque support, comportant une étape de dépôt d'une couche métallique et/ou de lithographie et/ou de gravure et/ou d'implantation ionique et/ou de nettoyage et/ou d'amincissement.

32. Procédé selon l'une des revendications 27 à 31, le transfert sur ledit substrat et/ou l'assemblage avec un substrat poignée étant réalisé par collage par adhérence moléculaire.

33. Procédé selon l'une des revendications 27 à 32, la couche d'adhérence étant en dioxyde de silicium ou en polymère.

34. Procédé selon l'une des revendications 2 à 25 ou 27 à 32, comportant en outre l'élimination éventuelle d'une deuxième couche d'arrêt.

35. Procédé selon l'une des revendications 1 à 34, la ou les sélectivités étant comprise (s) entre 2 et 10 ou entre 10 et 1000 ou supérieure(s) à 1000.

## Claims

1. Method for preparing the surface of a thin layer (28, 38, 48) or of a chip, this thin layer or this chip presenting a surface topology, therefore variations in height or level according to a direction perpendicular to a plane defined by the thin layer, this method including:
- the realization, above the surface of said thin layer or said chip, of at least one layer, called adhesive layer (22, 24, 32, 58, 54, 42), and of at least one layer, called first barrier layer (20, 21, 51, 52), between the adhesive layer and the surface of said thin layer or said chip, the adhesive layer being in a material of which etching presents selectivity in relation to the material of the barrier layer.

2. Method for transfer onto a substrate of a thin layer (28, 38, 48) or of a chip, this thin layer or this chip being supported by a support wafer (24, 84) and presenting a surface topology, therefore variations in height or level according to a direction perpendicular to a plane defined by the thin layer, this method including:
- a process for preparing the surface of said thin layer (28, 38, 48) or of said chip according to claim 1;
- the transfer of the thin layer or of the chip onto said substrate,
- the elimination of adhesive layers and of the first barrier layer, to find the initial topology again.

3. Method according to claim 2, the transfer including a prior assembly of the adhesive layer with a handle substrate (40, 60), as well as the elimination of all or part of the support wafer.

4. Method according to claim 3, further comprising the elimination of the handle substrate.

5. Method for processing of a thin layer (28, 38, 48) or of a chip, this thin layer or this chip being supported by a support wafer (24, 34) and presenting a surface topology, therefore variations in height or in level according to a direction perpendicular to a plane defined by the thin layer, this method including:
- a process for preparing the surface of said thin layer (28, 38, 48) or of said chip according to claim 1;
- an assembly of the adhesive layer with a handle substrate (40, 60),
- elimination of all or part of the support wafer, then:
* processing of the thin layer or of the chip from its face (47) not assembled with said handle substrate,
* or processing of a face (49, 49') of the support wafer not assembled with the thin layer or the chip,
- elimination of the handle substrate,
- elimination of adhesive layers and of the first barrier layer, to find the initial topology again of said thin layer or said chip.

6. Method according to claim 5, the processing of the thin layer or of the chip or of a face of the support wafer including a step for depositing a metallic layer and/or lithography and/or etching and/or ion implantation and/or cleaning and/or thinning.

7. Method according to one of claims 2 to 6, the transfer on said substrate and/or the assembly with a handle substrate being made by molecular bonding.

8. Method according to one of claims 2 to 5, the first barrier layer being made of a material of which etching presents selectivity in relation to the material beneath this barrier layer.

9. Method according to one of claims 2 to 8, the first barrier layer having a thickness between 10 nm and 500 nm and/or conformal with the surface of said thin layer or of said chip or with a thickness greater than 500 nm and is conformal with the surface of said thin layer or said chip.

10. Method according to one of claims 2 to 9, the variation(s) in level being between 10 nm and 5 µm.

11. Method according to one of claims 2 to 10, the surface of the thin layer or of the chip including electrical contact zones (24, 46).

12. Method according to one of claims 2 to 11, the adhesive layer (42) being of a mineral type.

13. Method according to claim 12, the adhesive layer being made of silicon dioxide.

14. Method according to one of claims 2 to 11, the adhesive layer being of an organic type.

15. Method according to claim 14, the adhesive layer being made of BCB-type polymer, or of an adhesive substance.

16. Method according to one of claims 2 to 15, the material of the first barrier layer (22) being made of nitride (Si3N4) or amorphous silicon and the material of the adhesive layer (32) of silicon oxide (SiO2).

17. Method according to one of claims 2 to 15, the Material of the first barrier layer (22) being oxide (SiO2) and the material of the adhesive layer (32) being silicon nitride (S13N4).

18. Method according to one of claims 2 to 17, the thin layer (38) or the chip being directly beneath the barrier layer.

19. Method according to claim 18, at least one part (39) of the surface of the thin layer or of the chip being made of an oxide or of an oxynitride or of a nitride.

20. Method according to claim 19, at least one other part of the surface of the thin layer or of the chip including contact zones.

21. Method according to one of claims 2 to 20, a second barrier layer (20), or protective layer, being present between the first barrier layer (22) and the surface of the thin layer or of the chip.

22. Method according to claim 21, this second barrier layer (20) being made of a material of which etching presents selectivity in relation to the surface material of the thin layer or of the chip.

23. Method according to one of claims 21 or 22, the second barrier layer (20) having a thickness between 10 nm and 500 nm.

24. Method according to one of claims 21 to 23, the second barrier layer being made of silicon oxide (SiO2).

25. Method according to one of claims 2 to 24, further including a step for preparation of the surface for bonding.

26. Method for preparing the surface of a thin layer (28, 38, 48) or a chip, the surface of this layer or of this chip including at least one layer of silicon nitride (Si3N4) or silicon oxynitride and metallic contact pads (56), this transfer method including:
- the realization, above the surface of said thin layer or of said chip, of at least one layer, called adhesive layer (22, 24, 32, 58, 54, 42) made of a material of which etching presents selectivity in relation to the nitride.

27. Method for transfer onto a substrate of a thin layer (38) or a chip, this thin layer or this chip being supported by a support wafer (34), and presenting a surface topology, therefore variations in height or level according to a direction perpendicular to a plane defined by the thin layer, the surface of this layer (38) or of this chip including at least one layer of silicon nitride (Si3N4) or silicon oxynitride and metallic contact pads (56), this transfer method including:
- a process for preparing the surface of said thin layer (28, 38, 48) or of said chip according to claim 26;
- the transfer of the thin layer or of the chip onto said substrate,
- elimination of the adhesive layer to find the initial topology again.

28. Method according to claim 27, the transfer including prior assembly of the adhesive layer with a handle substrate (40, 60), as well as the elimination of all or part of the support wafer.

29. Method according to claim 28, including, after transfer onto the substrate, the elimination of the handle substrate.

30. Method for processing a thin layer (38) or a chip, this thin layer or this chip being supported by a support wafer (24, 34), and presenting a surface topology, therefore variations in height or level according to a direction perpendicular to a plane defined by the thin layer, the surface of the thin layer (38) or of the chip including at least one layer of silicon nitride (S13N4) or silicon oxynitride and metallic contact pads (56), this transfer method including:
- a process for preparing the surface of said thin layer or of said chip according to claim 26;
- assembly of the adhesive layer with a handle substrate (40, 60),
- elimination of all or part of the support wafer, then:
* processing of the thin layer or of the chip from its face (47) not assembled with said handle wafer,
* or processing of a face (49, 49') of the support wafer not assembled with the thin layer or the chip,
- elimination of the handle wafer,
- elimination of the adhesive layer, to find the initial topology again.

31. Method according to claim 30, the processing of the thin layer or of the chip, or of a face of the support wafer, including a step for depositing a metallic layer and/or a step of lithography and/or en etching step and/or an ion implantation and/or a cleaning step and/or a thinning step.

32. Method according to one of claims 27 to 31, the transfer on said substrate and/or the assembly with a handle substrate being made by molecular bonding.

33. Method according to one of claims 27 to 32, the adhesive layer being made of silicon dioxide or polymer.

34. Method according to one of claims 2 to 25 or 27 to 32, further including the possible elimination of a second barrier layer.

35. Method according to one of claims 1 to 34, the selectivity or selectivities being between 2 and 10 or between 10 and 1000 or greater than 1000.

## Patentansprüche

1. Verfahren zur Vorbereitung der Oberfläche einer Dünnschicht (28, 38, 48) oder eines Halbleiterplättchens, wobei diese Dünnschicht oder dieses Halbleiterplättchen eine Oberflächentopologie aufweist, also Höhen- oder Niveauunterschiede in senkrechter Richtung in Bezug auf eine durch die Dünnschicht definierte Ebene, wobei dieses Verfahren umfasst:
- die Herstellung - auf der Oberfläche der genannten Dünnschicht oder des genannten Halbleiterplättchens - von wenigstens einer Schicht (22, 24, 32, 58, 54, 42), Haftschicht genannt, und wenigstens einer "erste Stoppschicht" (20, 21, 51, 52) genannten Schicht zwischen der Haftschicht und der Oberfläche der genannten Dünnschicht oder des genannten Halbeiterplättchens, wobei die Haftschicht aus einem Material ist, dessen Ätzung eine Selektivität in Bezug auf das Material der Stoppschicht aufweist.

2. Verfahren zur Übertragung eine Dünnschicht (28, 38, 48) oder eines Halbleiterplättchens auf ein Substrat, wobei diese Dünnschicht oder dieses Halbleiterplättchen durch eine Trägerplatte (24, 34) getragen wird und eine Oberflächentopologie aufweiset, also Höhen-oder Niveauunterschiede in senkrechter Richtung in Bezug auf eine durch die Dünnschicht definierte Ebene, wobei dieses Verfahren umfasst:
- ein Verfahren zur Vorbereitung der Oberfläche der Dünnschicht (28, 38, 48) oder des Halbleiterplättchens gemäß Anspruch 1,
- die Übertragung der Dünnschicht oder des Halbleiterplättchens auf das genannt te Substrat,
- die Eliminierung der Haftschicht und der ersten Stoppschicht, um die ursprüngliche Topologie der Dünnschicht oder des Halbleiterplättchens wiederzuerlangen.

3. Verfahren nach Anspruch 2, wobei die Übertragung ein vorausgehendes Zusammenfügen der Haftschicht mit einem Griffsubstrat (40, 60) sowie das Eliminierten der gesarnten Trägerplatte oder eines Teils von ihr umfasst.

4. Verfahren nach Anspruch 3, außerdem die Eliminierung des Griffsubstrats umfassend.

5. Verfahren zur Behandlung einer Dünnschicht (28, 38, 48) oder eines Halbleiterplättchens, wobei diese Dünnschicht oder dieses Halbleiterplättchen eine Oberflächentopologie aufweist, also Höhen- oder Niveauunterschiede in senkrechter Richtung in Bezug auf eine durch die Dünnschicht definierte Ebene, wobei dieses Verfahren umfasst:
- ein Verfahren zur Vorbereitung der Oberfläche der Dünnschicht (28, 38, 48) oder des Halbleiterplättchens gemäß Anspruch 1,
- ein Zusammenfügen der Haftschicht mit einem Griffsubstrat (40, 60),
- ein Eliminieren der gesamten Trägerplatte oder eines Teils von ihr, dann:
* eine Behandlung der nicht mit dem genannten Griffsubstrat zusammengefügten Seite (47) der Dünnschicht oder des Halbleiterplättchens,
* oder eine Behandlung einer nicht mit der Dünnschicht oder dem Halbleiterplättchen zusammengefügten Seite (49, 49') der Trägerplatte,
- das Eliminierten des Griffsubstrats,
- das Eliminieren der Haftschicht und der ersten Stoppschicht, um die ursprüngliche Topologie der Dünnschicht oder des Halbleiterplättchens wiederzuerlangen.

6. Verfahren nach Anspruch 5, wobei die Behandlung der Dünnschicht oder des Halbleiterplättchens oder einer Seite der Trägerplatte umfasst: einen Schritt zum Abscheidung einer metallischen und/oder lithografischen Schicht und/oder zur Ätzung und/oder zur lonenimplantation und/oder zur Reinigung und/oder zum Verjüngen bzw. Dünnermachen.

7. Verfahren nach einem der Ansprüche 2 bis 6, wobei das Übertragen auf das genannte Substrat und/oder das Zusammenfügen mit einem Griffsubstrat durch Klebung mittels Molekularhaftung realisiert wird.

8. Verfahren nach einem der Ansprüche 2 bis 7, wobei die erste Stoppschicht aus einem Material ist, dessen Ätzung eine Selektivität in Bezug auf das Material unter dieser Stoppschicht aufweist.

9. Verfahren nach einem der Ansprüche 2 bis 8, wobei die erste Stoppschicht eine Dicke hat, die enthalten ist zwischen 10 nm und 500 nm und/oder konform ist zur Oberfläche der Dünnschicht oder des Halbleiterplättchens, oder eine Dicke von mehr als 500 nm hat und konform ist zur Oberfläche der Dünnschicht oder des Halbleiterplättchens.

10. Verfahren nach einem der Ansprüche 2 bis 9, wobei der (die) Niveauunterschied(e) enthalten ist (sind) zwischen 10 nm und 5 µm.

11. Verfahren nach einem der Ansprüche 2 bis 10, wobei die Oberfläche der Dünnschicht oder des Halbleiterplättchens elektrische Kontaktzonen (24, 46) umfasst.

12. Verfahren nach einem der Ansprüche 2 bis 11, wobei die Haftschicht (42) vom mineralischen Typ ist.

13. Verfahren nach Anspruch 12, wobei die Haftschicht aus Siliciumdioxid ist.

14. Verfahren nach einem der Ansprüche 2 bis 11, wobei die Haftschicht vom organischen Typ ist.

15. Verfahren nach Anspruch 14, wobei die Haftschicht aus Polymer des BCB-Typs oder eine klebefähige Substanz ist.

16. Verfahren nach einem der Ansprüche bis 15, wobei das Material der ersten Stoppschicht (22) Nitrid (Si₃N₄) oder amorphes Silicium ist und das Material der Haftschicht (32) SiO₂.

17. Verfahren nach einem der Ansprüche 2 bis 15, wobei das Material der ersten Stoppschicht (22) SiO₂ ist und das Material der Haftschicht (32) Si₃N₄.

18. Verfahren nach einem der Ansprüche 2 bis 17, wobei die Dünnschicht (38) oder das Hafbfesterpfattchen direkt unter der Stoppschicht liegt.

19. Verfahren nach Anspruch 18, wobei wenigstens ein Teil (39) der Dünnschicht oder des Halbleiterplättehens aus einem Oxid oder einem Oxinitrid oder einem Nitrid ist.

20. Verfahren nach Anspruch 19, wobei wenigstens ein anderer Teil der Dünnschicht oder des Halbleiterplättchens Kontaktzonen umfasst.

21. Verfahren nach einem der Ansprüche 2 bis 20, wobei eine zweite Stoppschicht, oder Schutzschicht, vorhanden ist zwischen der ersten Stoppschicht (22) und der Oberfläche der Dünnschicht oder des Halbieiterpldttchens.

22. Verfahren nach Anspruch 21, wobei diese zweite Stoppschicht (20) aus einem Material ist, dessen Ätzung eine Selektivität aufweist in Bezug auf das Oberflächenmaterial der Dünnschicht oder des Halbleiterplättchens.

23. Verfahren nach einem der Ansprüche 21 oder 22, wobei die zweite Stoppschicht (20) eine zwischen 10 nm und 500 nm enthaltene Dicke aufweist.

24. Verfahren nach einem der Ansprüche 2 bis 23, wobei die zweite Stoppschicht aus SiO₂ ist.

25. Verfahren nach einem der Ansprüche 2 bis 24 mit außerdem einem Schritt zur Vorbereitung der Oberfläche hinsichtlich einer Klebung.

26. Verfahren zur Vorbereitung der Oberfläche einer Dünnschicht (28, 38, 48) oder eines Halbleiterplättchens, wobei die Oberfläche dieser Dünnschicht (38) oder dieses Halbleiterplättchens wenigstens eine Schicht aus Siliziumnitrid (Si₃N₄) oder Siliciumoxinitrid und metallische Kontaktelemente (56) umfasst und dieses Verfahren dabei umfasst:
- das Realisieren von wenigstens einer Haftschicht genannten Schicht (22, 24, 32, 58, 54, 42) auf der Oberfläche der genannten Dünnschicht oder des Halbleiterplättchens aus einem Material, dessen Ätzung eine Selektivität in Bezug auf das darunterliegende Material aufweist.

27. Verfahren zur Übertragung einer Dünnschicht (38) oder eines Halbleiterplättchens auf ein Substrat, wobei diese Dünnschicht oder dieses Halbleiterplättchen durch eine Trägerplatte (24, 34) getragen wird und eine Oberflächentopologie aufweiset, also Höhen- oder Niveauunterschiede in senkrechter Richtung in Bezug auf eine durch die Dünnschicht definierte Ebene, wobei die Oberfläche der Dünnschicht (38) oder des Halbleiterplättchens wenigstens eine Schicht aus Siliciumnitrid (Si₃N₄) oder Siliciumoxinitrid und metallische Kontaktelemente (56) umfasst und dieses Verfahren dabei umfasst:
- ein Verfahren zur Vorbereitung der Oberfläche der Dünnschicht oder des Halbleiterplättchens gemäß. Anspruch 26,
- die Übertragung der Dünnschicht oder des Halbleiterplättchens auf das genannte Substrat,
- die Eliminierung der Haftschicht, um die ursprüngliche Topologie der Dünnschicht oder des Halbleiterplättchens wiederzuerlangen.

28. Verfahren nach Anspruch 27, wobei die Übertragung ein vorausgehendes Zusammenfügen der Haftschicht mit einem Griffsubstrat (40, 60) sowie das Eliminieren der gesamten Trägerplatte oder eines Teils von ihr umfasst.

29. Verfahren nach Anspruch 28, die Eliminierung des Griffsubstrats nach der Übertragung auf das Substrat umfassend.

30. Verfahren zur Behandlung eine Dünnschicht (38) oder eines Halbleiterplättchens, wobei diese Dünnschicht oder dieses Halbleiterplättchen durch eine Trägerplatte (24, 34) getragen wird und eine Oberflächentopologie aufweist, also Höhen- oder Niveauunterschiede in senkrechter Richtung in Bezug auf eine durch die Dünnschicht definierte Ebene, wobei die Oberfläche der Dünnschicht (38) oder des Halbleiterplättchens wenigstens eine Schicht aus Siliciumnitrid (Si₃N₄) oder Siliciumoxinitrid und metallische Kontaktelemente (56) umfasst und dieses Verfahren dabei umfasst:
- ein Verfahren zur Vorbereitung der Oberfläche der Dünnschicht oder des Halbleiterplättchens gemäß Anspruch 26,
- ein Zusammenfügen der Haftschicht mit einem Griffsubstrat (40, 60),
- eine Eliminierung eines gesamten Trägerplatte oder eines Teils von ihr, sodann:
* eine Behandiung der nicht mit dem genannten Griffsubstrat zusammengefügten Seite (47) der Dünnschicht oder des Halbleiterplättchens, oder
* eine Behandlung einer nicht mit der Dünnschicht oder dem Halbieiterplättchen zusammengefügten Seite (49, 49') der Trägerplatte,
- das Eliminieren des Griffsubstrats,
- das Eliminieren der Haftschicht, um die ursprünglich Topologie der Dünnschicht oder des Halbleiterplättchens wiederzuerlangen.

31. Verfahren nach Anspruch 30, wobei die Behandlung der Dünnschicht oder des Halbleiterplättchens oder einer Seite der Trägerplatte umfasst: einen Schritt zur Abscheidung einer metallischen und/oder lithografischen Schicht und/oder zur Ätzung und/oder zur lonenimplantation und/oder zur Reinigung und/oder zum Verjüngen bzw. Dünnermachen.

32. Verfahren nach einem der Ansprüche 27 bis 31, wobei die Übertragung auf das genannte Substrat und/oder die Zusammenfügung mit einem Griffsubstrat durch Klebung mittels Molekularhaftung realisiert wird.

33. Verfahren nach einem der Ansprüche 27 bis 32, wobei die Haftschicht aus Siliziumdioxid oder aus Polymer ist.

34. Verfahren nach einem der Ansprüche 2 bis 25 oder 27 bis 32, außerdem die eventuelle Eliminierung einer zweiten Stoppschicht umfassend.

35. Verfahren nach einem der Ansprüche 1 bis 34, wobei die Selektivität(en) zwischen 2 und 10 oder zwischen 10 und 1000 enthalten oder höher als 1000 ist (sind).
